# EUROPEAN PATENT SPECIFICATION

(11) **EP 1 758 129 B1**
(45) Date of publication and mention of the grant of the patent: **23.07.2008**
(21) Application number: 06118721.7
(22) Date of filing: 10.08.2006
(51) Int. Cl.: G11C 19/00, G11C 19/18, G11C 19/28

(54) **Shift register circuit**
Schieberegisterschaltung
Circuit d'enregistrement de décalage

(30) Priority: 22.08.2005 KR 20050076980
(43) Date of publication of application: 28.02.2007
(73) Proprietor: Samsung SDI Co., Ltd., Suwon-si Gyeonggi-do (KR)
(72) Inventor: Chung, Bo Yong Legal & IP Team, Samsung SDI Co LTD, Gyeonggi-do (KR); Kim, Hong Kwon Legal & IP Team, Samsung SDI Co LTD, Gyeonggi-do (KR); Kim, Keum Nam Legal & IP Team, Samsung SDI Co LTD, Gyeonggi-do (KR)
(74) Representative: Hengelhaupt, Jürgen

(56) References cited:
- EP-A- 0 651 395
- EP-A- 1 445 862
- WO-A-02/065062
- GB-A- 2 343 068
- US-A1- 2002 150 199

## Description

### BACKGROUND OF THE INVENTION

### 1. Field of the Invention

The present invention relates to a driving circuit for an active matrix display device, more particularly to a shift register configured to drive pixel rows in an organic light emitting display.

### 2.Description of the Related Art

Generally, an active matrix display device such an organic light emitting display includes a pixel array in a matrix pattern arranged near intersections of data lines and scan lines.

Here, the scan lines constitute horizontal lines (or row lines) of a matrix pixel portion, and are configured to sequentially provide a signal to the matrix pixel array with a shift register circuit within a scan driver.

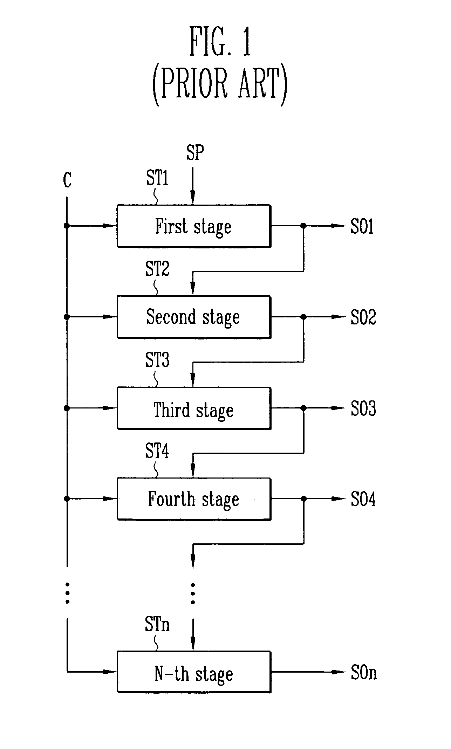

FIG. 1 is a block diagram showing a configuration of a conventional shift register. With reference to FIG. 1, the conventional shift register includes a plurality of stages ST1 to STn, which are connected to a start pulse SP input line. The plurality of stages ST1 to STn sequentially shift the start pulse SP so as to generate output signals SO1 to SOn. Each of the plurality of stages ST1 to STn receives an output signal of a next previous stage as a start pulse and generates an output signal SOn in response to the received start pulse.

As a result, the stages generate output signals SO1 to SOn in such a manner that the start pulse is sequentially shifted from SO1 to SOn, which can be used by a matrix pixel array of an organic light emitting display.

Such a shift register is classified as a dynamic shift register or a static shift register. The dynamic shift register is characterized by having a small number of thin film transistors (TFTs) per stage and by having a single structure. However, the dynamic shift register has disadvantages that include a low range of operable frequencies, and high power consumption.

In contrast to this, the static shift register needs many TFTs per stage. However, the static shift register has advantages that include that it can be operated over a wide frequency band and that power consumption is low.

When designing a shift register that can be used in an active matrix display device such as an organic light emitting display, a circuit characterized by a small number of TFTs without deterioration in functionality is needed. High reliability and low power consumption is also needed.

GB-A 2 343 068 discloses a flip-flop for use in a shift-register of a scan pulse generator for use in an LCD comprising only NMOS transistors which are not available in Organic LED display devices. The flip-flop is a dynamic flip-flop which can be problematic because the charge stored in the flip-flop corresponding to a previous logic input value and accordingly the start pulse perpetuating through the shift register can be lost.

### SUMMARY OF CERTAIN INVENTIVE ASPECTS

Accordingly, it is an aspect of the present invention to provide a shift register circuit that improves yield, reduces cost, utilizes a pull-swing drive, and has low power consumption.

The shift register circuit is a 4-phase shift register circuit as defined in claim 1.

Preferred embodiments are defined in the dependent claims.

### BRIEF DESCRIPTION OF THE DRAWINGS

These and/or other aspects and advantages of the invention will become apparent and more readily appreciated from the following detailed description of certain aspects, taken in conjunction with the accompanying drawings of which:

FIG. 1 is a block diagram showing a schematic configuration of a conventional shift register (PRIOR ART);

FIG. 2 is a block diagram showing a schematic configuration of a shift register circuit according to an embodiment;

FIG. 3 is a detailed circuit schematic diagram showing one register stage in the shift register circuit shown in FIG. 2; and

FIG. 4 is an input/output signal waveform timing diagram of the stage shown in FIG. 3.

### DETAILED DESCRIPTION OF CERTAIN INVENTIVE EMBODIMENTS

Embodiments illustrating certain embodiments will be described with reference to the accompanying drawings. Herein, when a first element is connected to a second element, the first element may be directly connected to the second element and may be indirectly connected to the second element via a third element. Furthermore, certain elements are omitted for clarity. Also, like reference numerals refer to like elements throughout.

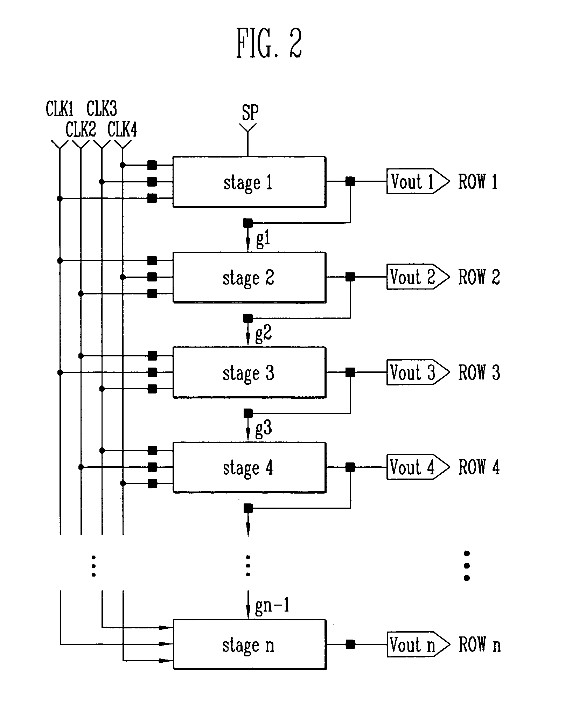

FIG. 2 is a block diagram showing a construction of a shift register circuit according to one exemplary embodiment. As shown in FIG. 2, the shift register circuit according to this embodiment includes n stages, where n is an integer. The n stages are dependently connected to a start pulse SP input line, and each register stage is connected to 3 of 4 clock signals CLK1 to CLK4.

Output lines Vout 1 to Vout n of the n register stages in the shift register of FIG. 2, are connected to n row lines ROW1 to ROWn, respectively. Each of the n register stages receives only 3 clock signals among first to fourth clock signals CLK1 to CLK4 that are sequentially phase-shifted.

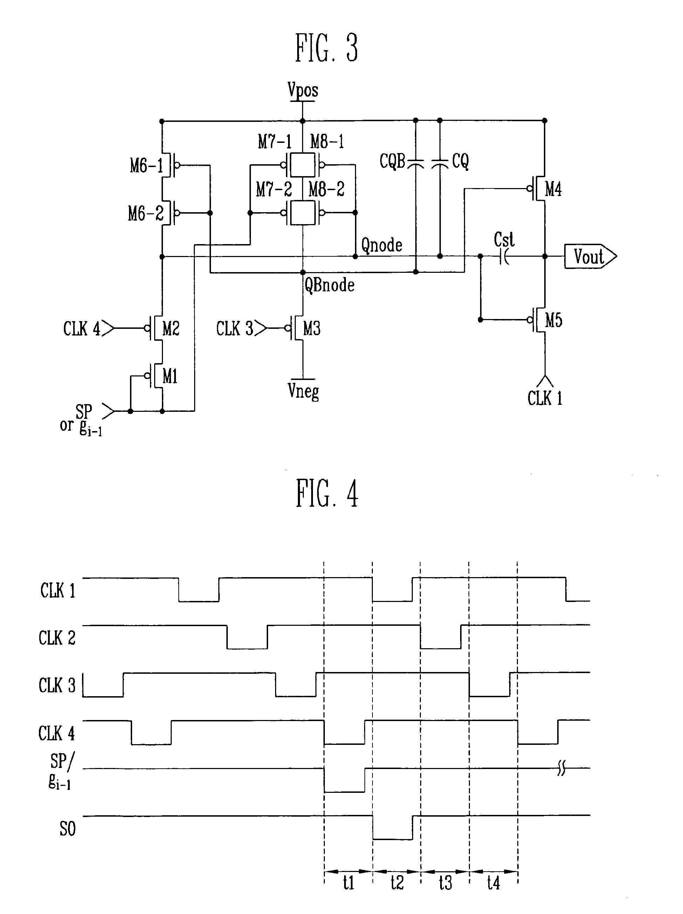

In this example embodiment, the clock signals CLK1 through CLK4 are sequentially arranged in such a way that the CLKx is a next shifted version of CLKx-1 and that the sequence wraps around from CLK4 to CLK1 such that CLK1 is a shifted version of CLK4. An example of such an arrangement is shown in FIG. 4. As shown in FIG. 2, each of the inputs of the second register stage receives the next clock signal in the clock signal sequence, as the corresponding input of the first register stage. That is, a first input of the first register stage receives CLK4 and the corresponding first input of the second register stage receives CLK1. Similarly, each of the inputs of the third register stage receives the next clock signal in the clock signal sequence, as the corresponding input of the second register stage. For example, the third register stage input corresponding to the second register stage input receiving CLK1, receives CLK 2. This pattern continues throughout the n stages.

After a start pulse SP is supplied to the first register stage, in response to the start pulse SP and the clock signals CLK4, CLK3, and CLK4 the first register stage produces an output Vout 1. The output Vout1 is used to drive ROW1 and is also used as a start pulse g1 for stage 2. Accordingly, once the start pulse SP is provided to stage 1 each respective register stage shifts the start pulse SP according to the clock signals provided thereto. This produces a sequence of pulses on the outputs Vout1 to Voutn which are used to drive row lines ROW1 to ROWn. Hereinafter, operation of stage 1, receiving first, third, and fourth clock signals will be explained as an example of operation of each of the stages.

FIG. 3 is a detailed circuit diagram showing a first register stage in the shift register circuit shown in FIG. 2.

With reference to FIG. 3, the stage includes a first PMOS transistor M1, a second PMOS transistor M2, a third PMOS transistor M3, sixth -1 and sixth-2 PMOS transistors M6-1 and M6-2, seventh-1 and seventh-2 PMOS transistors M7-1 and M7-2, eighth-1 and eighth-2 PMOS transistors M8-1 and M8-2, a fourth PMOS transistor M4, and a fifth PMOS transistor M5. The first PMOS transistor M1 includes a gate electrode and a drain electrode that are coupled to astart pulse signal. The second PMOS transistor M2 is coupled between a first node Qnode and the first PMOS transistor M1, and a gate electrode thereof is coupled to a first clock signal input line labeled CLK4. The third PMOS transistor M3 is coupled between a second node QBnode and a second power supply Vneg, and a gate electrode thereof is coupled to a second clock signal input line labeled CLK3. The sixth-1 and sixth-2 PMOS transistors M6-1 and M6-2 are coupled between a first power supply Vpos and the first node Qnode, and gate electrodes thereof are each coupled to the second node QBnode. The seventh-1 and seventh-2 PMOS transistors M7-1 and M7-2 are coupled between the first power supply Vpos and the second node QBnode, and gate electrodes thereof are coupled to the start pulse (SP) input line. The eighth-1 and eighth-2 PMOS transistors M8-1 and M8-2 are coupled between the first power supply Vpos and the second node QBnode, and gate electrodes thereof are coupled to the first node Qnode. The fourth PMOS transistor M4 is coupled to the second node QBnode, a first power supply Vpos, and an output line. The fifth PMOS transistor M5 is coupled to the first node Qnode, a third clock signal line labeled CLK1, and the output line. As the stage shown in FIG. 3 is stage 1 of FIG. 2, the start pulse shown is start pulse SP, the first clock signal line is connected to clock signal CLK4, the second clock signal line is connected to clock signal CLK3, the third clock signal line is connected to clock signal CLK1, and the output line is connected to Vout 1.

The stage shown in FIG. 3 further includes a first capacitor CQ coupled between the first power supply Vpos and the first node Qnode, a second capacitor CQB coupled between the first power supply Vpos and the second node QBnode, and a storage capacitor Cst coupled between the first node Qnode and the output line.

Hereinafter, the operation of the stage shown in FIG. 3 will be described in relation to the drive waveform shown in FIG. 4.

During a first time period t1, a first start pulse SP of a low logic level is supplied to gate and drain electrodes of the first PMOS transistor M1, and gate electrodes of the seventh-1 and seventh-2 PMOS transistors M7-1 and M7-2.

Furthermore, the fourth clock signal CLK4 of a low logic level is provided to a gate electrode of the second PMOS transistor M2. During the first time period t1, the first and third clock signals CLK1 and CLK3 supplied to the first and third clock signal input lines maintain a high logic level.

In response, the second PMOS transistors M1 and M2 are turned on, and the first node Qnode is charged into a low logic level voltage, and a first power supply is applied to the second node QBnode because the seventh-1 and seventh-2 PMOS transistors M7-1 and M7-2 and the eighth-1 and eighth-2 PMOS transistors M8-1 and M8-2 are also turned on.

Furthermore, as the first node Qnode is charged into a low logic level voltage, the fifth PMOS transistor M5 whose gate electrode being connected to the first node Q is turned on. As the second node QBnode is charged into a high logic level voltage, the fourth PMOS transistor M4 whose gate electrode is connected to the second node QB is turned off.

Accordingly, since the first clock signal CLK1 input through a source electrode of the fifth PMOS transistor M5 is output as a high logic level during the first time period t1, through an output line, which is connected to a drain electrode of the fifth PMOS transistor M5. That is, during the first time period t1, as shown, the signal SO output through the output line becomes a high logic level.

Moreover, the storage capacitor Cst coupled between the first node Qnode and the output line is charged with a voltage due a potential difference between the first node Qnode and the output line during the first time period t1.

As seen in FIG. 4, during a second time period t2, the start pulse and the fourth clock signal CLK4 transition to a high logic level. Also, the first clock signal CLK1 transitions to a low logic level. However, the third clock signal CLK3 maintains a high logic level as during the first time period t1.

In response to the applied clock and start pulse signals, all PMOS transistors except PMOS transistor M5 are turned off. PMOS transistor M5 remains on because of its gate voltage.

Accordingly, since the first clock signal CLK1 is a low logic level during the second time period t2, the low logic level of the first clock signal CLK1 is output through the output line, which is connected to a drain electrode of the fifth PMOS transistor M5.

That is, during the second time period t2, as shown, the signal SO output through the output line becomes a low logic level.

However, as shown in FIG. 4 during the second time period t2, the first clock signal CLK1 transitions to a high logic level. In response, the signal SO follows the first clock signal CLK1 and also transitions to a high logic level during the second time period t2.

An important function of the eighth-1 and eighth-2 PMOS transistors M8-1 and M8-2 becomes apparent during the second time period t2. During this time period, the start pulse signal is a high logic level, and the seventh-1 and seventh-2 PMOS transistors M7-1 and M7-2 are off, and accordingly do not drive the second node QBnode. The eighth-1 and eighth-2 PMOS transistors M8-1 and M8-2, however, are on during the second time period t2 so that the high logic level is actively maintained on the second node QBnode. This is advantageous as the second node QBnode could otherwise acquire a lower voltage through mechanisms such as, but not limited to, capacitive coupling, charge injection, or leakage. Having the second node QBnode actively driven helps to prevent a situation where the fourth PMOS transistor M4 is partially on while the output is being driven to a low logic level. If the fourth PMOS transistor M4 were to be partially on while the output is being driven to a low logic level, power consumption would increase and the output logic level would be uncertain. The function of the eighth-1 and eighth-2 PMOS transistors M8-1 and M8-2 is at least to substantially prevent this situation.

Next, during the third time period t3, the second clock signal CLK2 is the only signal which changes. As stage 1 is not connected to the second clock signal CLK2, the state of stage 1 does not change during the third time period t3.

During a fourth time period t4, the third clock CLK3 transitions to a low logic level. Other input signals remain unchanged.

Accordingly, during the fourth time period t4, the third PMOS transistor M3 is turned on and a second power signal Vneg is connected to the second node QBnode, thereby providing a low logic level to the second node QBnode.

In response to the low logic level on the second node QBnode, the sixth-1 and sixth-2 PMOS transistors M6-1 and M6-2 are turned on, and the first power supply Vpos is connected to the first node Qnode, therby providing a high logic level to the first node Qnode. In this respect, the sixth-1 and sixth-2 PMOS transistors M6-1 and M6-2 provide a similar function as the function described above with reference to the eighth-1 and eighth-2 PMOS transistors M8-1 and M8-2 with respect to the second node QBnode. The sixth-1 and sixth-2 PMOS transistors M6-1 and M6-2 drive the first node Qnode to a high logic level during the fourth time period t4 to ensure that the fifth PMOS transistor M5 is off while the fourth PMOS transistor M4 is driving the output node. This is advantageous as the first node Qnode could otherwise acquire a lower voltage through mechanisms such as, but not limited to, capacitive coupling, charge injection, or leakage.

In addition, as the second node QBnode transitions to a low logic level, the fourth PMOS transistor M4 is turned on. Accordingly, the first power supply Vpos is connected to the output line.

That is, during the fourth time period t4, as shown, a signal SO output through the output line has a high logic level.

Throughout the first through fourth time periods t1-t4, the first capacitor CQ and the second capacitor CQB function to reduce the variation of voltages on the first and second nodes Q and QB wherein the first capacitor CQ is coupled between the first power supply Vpos and the first node Q, and the second capacitor CQB is coupled between the first power supply Vpos and the second node QB.

The first, second, third, sixth, seventh, and eighth PMOS transistors, M1, M2, M3, M6, M7, and M8 are an input stage of the shift register stage of FIG. 3. Likewise, the fourth and fifth PMOS transistors M4, M5 are the output stage, where the first and second nodes Qnode and QBnode are the inputs to the output stage. A power saving feature of the shift register stage of FIG. 3 is that the input stage (represented by M1, M2, M3, M6, M7, and M8) functions to ensure that the inputs (Qnode and QBnode) to the output stage (represented by M4, M5) are complementary, that is when one has a low logic level the other has a high logic level. When the inputs (Qnode and QBnode) to the output stage (represented by M4, M5) are thusly complimentary, only one of the output transistors M4 and M5 can be on. This is accomplished because, as noted above, when the first node Qnode has a low logic level the eighth-1 and eighth-2 PMOS transistors M8-1 and M8-2 drive the second node QBnode to a high logic level, and similarly, when the second node QBnode has a low logic level the sixth -1 and sixth-2 PMOS transistors M6-1 and M6-2 drive the first node Qnode to a high logic level. This saves power because the fourth and fifth transistors M4 and M5 in the output stage do not simultaneously drive the output to different logic levels.

Accordingly, with the clock signals arranged as shown, an output pulse is driven to the output of each register stage one time period after a start pulse is given to the start pulse input. Therefore, a cascaded series of these register stages with the output of an mth register stage being connected to the start pulse input of an (m+1)th register stage produces a series of row pulse signals which are sequentially activated.

As apparent from the above description, in accordance with the present invention, a manufacturing yield is improved, the cost is reduced, a pull-swing drive and low power consumption may be embodied.

## Claims

1. A shift register circuit comprising n register stages (stage 1, stage 2, stage 3, stage 4, stage n), wherein n is an integer, and each register stage (stage 1, stage 2, stage 3, stage 4, stage n) comprises four input lines, the first to third input lines are connected to three of four clock signal supply lines (CLK1, CLK2, CLK3, CLK4), and the fourth input line is connected to a start pulse input line (SP) or an output voltage line (g1, g2, g3, gn-1) of a previous register stage (stage 1, stage 2, stage 3, stage 4), wherein each of the n register stages (stage 1, stage 2, stage 3, stage 4, stage n) comprises:
an input stage comprising a first transistor (M1), a second transistor (M2), and third transistor (M3) and a sixth and a seventh transistor section; and
an output stage comprising a fourth transistor (M4) and fifth transistor (M5) configured to receive complementary first and second inputs from the input stage;
wherein the input stage is configured such that whenever the first input has a first logic level, the second input is driven so as to have a logic level opposite to the first logic level;
wherein
the first transistor (M1) is comprising a first gate electrode and a first drain electrode, wherein the first gate and the first drain are coupled to an output voltage line (gi-1) of a previous register stage or a first start pulse input line (SP);
the second transistor (M2) is coupled between a first node (Qnode) and the first transistor (M1) and comprising a second gate electrode, the second gate electrode being coupled to a first clock signal line;
the third transistor (M3) is comprising a third gate electrode, the third gate electrode being coupled to a second clock signal line;
the fourth transistor (M4) is coupled to a second node (QBnode), a first power supply (Vpos), and an output voltage line (Vout) of the current register stage;
the fifth transistor (M5) is coupled to the first node (Qnode), a third clock signal line, and the output voltage line (Vout) of the current register stage;
the sixth transistor section (M6-1, M6-2) is coupled to the first power supply (Vpos), the second node (QBnode), and the first node (Qnode); and
the seventh transistor section (M7-1, M7-2) is coupled to the first power supply (Vpos), the start pulse input line or the output voltage line of a previous register stage;
each of the n register stages being **characterised by**:
the third transistor of the input stage is coupled between the second node (QBnode) and a second power supply (Vneg); the input stage of each register stage further comprising
an eighth transistor section (M8-1, M8-2) coupled to the first power supply (Vpos), the first node (Qnode) and the second node (QBnode).

2. The shift register circuit according to the preceding claim, wherein each of the n register stages (stage 1, stage 2, stage 3, stage 4, stage n) are configured to receive three different phase-shifted clock signals (CLK1, CLK2, CLK3, CLK4) and a start pulse (SP, g1, g2, g3, gn -1).

3. The shift register circuit according to one of the preceding claims, wherein each register stage (stage 1, stage 2, stage 3, stage 4, stage n) is configured to output a single pulse (Vout 1, Vout 2, Vout 3, Vout 4, Vout n) in response to the three different phase-shifted clock signals and the start pulse (SP, g1, g2, g3, gn-1).

4. The shift register circuit as claimed in claim 1, wherein the first to fifth transistors are PMOS transistors.

5. The shift register circuit as claimed in claim 1, wherein the transistor sections are PMOS transistors.

6. The shift register circuit as claimed in claim 1, wherein the first to fifth transistors are NMOS transistors.

7. The shift register circuit as claimed in claim 1, wherein the transistor sections are NMOS transistors.

8. The shift register circuit according to claim 1, wherein the sixth transistor section includes sixth-1 and sixth-2 transistors, wherein the sixth-1 and sixth-2 transistors are connected to each other in series and are connected to each other so as to receive the same gate voltage.

9. The shift register circuit according to claim 1, wherein the seventh transistor section includes seventh-1 transistor and seventh-2 transistors, wherein the seventh-1 transistor and seventh-2 transistors are connected to each other in series and are connected to each other so as to receive the same gate voltage.

10. The shift register circuit according to claim 1, wherein the eighth transistor section includes eighth-1 and eighth-2 transistors wherein the eighth-1 and eighth-2 transistors are connected to each other in series and are connected to each other so as to receive the same gate voltage.

11. The shift register circuit according to one of the preceding claims, wherein the first to third input lines are configured to receive three different phase-shifted clock signals.

12. The shift register circuit as claimed in claim 11, further comprising first to fourth clock signal lines (CLK1, CLK2, CLK3, CLK4) adapted to provided first to fourth clock signals, wherein the first clock signal is a version of the fourth clock signal phase-shifted by a selected amount and the second to fourth clock signals are each versions of the next previous clock signal phase-shifted by the selected amount, wherein the first, second, and third signal input lines of at least one of the register stages are configured to receive the fourth, third, and first clock signals, respectively.

13. The shift register circuit according to one of the preceding claims, each of the n register stages further comprising:
a first capacitor coupled between the first power supply (Vpos) and the first node (Qnode);
a second capacitor coupled between the first power supply (Vpos) and the second node (QBnode); and
a storage capacitor coupled between the first node (Qnode) and the output line.

14. The shift register circuit according to claim 1, wherein at least one of the sixth transistor section, the seventh transistor section, and the eighth transistor section comprises a single transistor.

15. A display panel comprising the shift register circuit as claimed in one of the preceding claims.

## Patentansprüche

1. Schieberegisterschaltung, aufweisend n Registerstufen (Stufe 1, Stufe 2, Stufe 3, Stufe 4, Stufe n), wobei n eine ganze Zahl ist, und wobei jede Registerstufe (Stufe 1, Stufe 2, Stufe 3, Stufe 4, Stufe n) vier Eingangsleitungen aufweist, wobei die erste bis dritte Eingangsleitung mit drei oder vier Taktsignalversorgungsleitungen (CLK1, CLK2, CLK3, CLK4) verbunden sind, und wobei die vierte Eingangsleitung mit einer Startpuls-Eingangsleitung (SP) oder einer Ausgangsspannungsleitung (g1, g2, g3, gn-1) einer vorhergehenden Registerstufe (Stufe 1, Stufe 2, Stufe 3, Stufe 4) verbunden ist, und wobei jede der n Registerstufen (Stufe 1, Stufe 2, Stufe 3, Stufe 4, Stufe n) aufweist:
eine Eingangsstufe, die einen ersten Transistor (M1), einen zweiten Transistor (M2) und einen dritten Transistor (M3) sowie einen sechsten und einen siebten Transistorabschnitt aufweist; und
eine Ausgangsstufe, die einen vierten Transistor (M4) und einen fünften Transistor (M5) aufweist, die konfiguriert sind, von der Eingangsstufe einen ersten und zweiten Komplementäreingang zu erhalten;
wobei die Eingangsstufe derart konfiguriert ist, dass der zweite Eingang immer dann, wenn der erste Eingang einen ersten logischen Pegel aufweist, so angesteuert wird, dass er einen logischen Pegel, der dem ersten logischen Pegel entgegengesetzt ist, aufweist;
wobei
der erste Transistor (M1) eine erste Gate-Elektrode und eine erste Drain-Elektrode aufweist, wobei das erste Gate und die erste Drain an eine Ausgangsspannungsleitung (g1-1) einer vorhergehenden Registerstufe oder eine erste Startpuls-Eingangsleitung (SP) gekoppelt sind;
der zweite Transistor (M2) zwischen einen ersten Knoten (Qnode) und den ersten Transistor (M1) gekoppelt ist und eine zweite Gate-Elektrode aufweist, wobei die zweite Gate-Elektrode an eine erste Taktsignalleitung gekoppelt ist;
der dritte Transistor (M3) eine dritte Gate-Elektrode aufweist, wobei die dritte Gate-Elektrode an eine zweite Taktsignalleitung gekoppelt ist;
der vierte Transistor (M4) an einen zweiten Knoten (QBnode), eine erste Spannungsversorgung (Vpos) und eine Ausgangsspannungsleitung (Vout) der aktuellen Registerstufe gekoppelt ist;
der fünfte Transistor (M5) an den ersten Knoten (Qnode), eine dritte Taktsignalleitung und die Ausgangsspannungsleitung (Vout) der aktuellen Registerstufe gekoppelt ist;
der sechste Transistorabschnitt (M6-1, M6-2) an die erste Spannungsversorgung (Vpos), den zweiten Knoten (QBnode) und den ersten Knoten (Qnode) gekoppelt ist; und
der siebte Transistorabschnitt (M7-1, M7-2) an die erste Spannungsversorgung (Vpos), die Startpuls-Eingangsleitung oder die Ausgangsspannungsleitung einer vorhergehenden Registerstufe gekoppelt ist;
wobei jede der n Registerstufen **dadurch gekennzeichnet ist, dass**
der dritte Transistor der Eingangsstufe zwischen den zweiten Knoten (QBnode) und eine zweite Spannungsversorgung (Vneg) gekoppelt ist; wobei die Eingangsstufe jeder Registerstufe weiterhin aufweist:
einen achten Transistorabschnitt (M8-1, M8-2), der an die erste Spannungsversorgung (Vpos), den ersten Knoten (Qnode) und den zweiten Knoten (QBnode) gekoppelt ist.

2. Schieberegisterschaltung nach dem vorhergehenden Anspruch, wobei jede der n Registerstufen (Stufe 1, Stufe 2, Stufe 3, Stufe 4, Stufe n) konfiguriert ist, drei verschiedene phasenverschobene Taktsignale (CLK1, CLK2, CLK3, CLK4) und einen Startpuls (SP, g1, g2, g3, gn-1) zu erhalten.

3. Schieberegisterschaltung nach einem der vorhergehenden Ansprüche, wobei jede Registerstufe (Stufe 1, Stufe 2, Stufe 3, Stufe 4, Stufe n) konfiguriert ist, in Reaktion auf die drei verschiedenen phasenverschobenen Taktsignale und den Startpuls (SP, g1, g2, g3, gn-1) einen einzelnen Puls (Vout 1, Vout 2, Vout 3, Vout 4, Vout n) auszugeben.

4. Schieberegisterschaltung nach Anspruch 1, wobei der erste bis fünfte Transistor PMOS-Transistoren sind.

5. Schieberegisterschaltung nach Anspruch 1, wobei die Transistorabschnitte PMOS-Transistoren sind.

6. Schieberegisterschaltung nach Anspruch 1, wobei der erste bis fünfte Transistor NMOS-Transistoren sind.

7. Schieberegisterschaltung nach Anspruch 1, wobei die Transistorabschnitte NMOS-Transistoren sind.

8. Schieberegisterschaltung nach Anspruch 1, wobei der sechste Transistorabschnitt einen sechsten-1 und einen sechsten-2 Transistor aufweist, wobei der sechste-1 und der sechste-2 Transistor miteinander in Serie geschaltet sind und miteinander verbunden sind, so dass sie die gleiche Gate-Spannung erhalten.

9. Schieberegisterschaltung nach Anspruch 1, wobei der siebte Transistorabschnitt einen siebten-1 Transistor und siebte-2 Transistoren aufweist, wobei der siebte-1 Transistor und die siebten-2 Transistoren miteinander in Serie geschaltet sind und miteinander verbunden sind, so dass sie die gleiche Gate-Spannung erhalten.

10. Schieberegisterschaltung nach Anspruch 1, wobei der achte Transistorabschnitt einen achten-1 und achten-2 Transistor aufweist, wobei der achte-1 und der achte-2 Transistor miteinander in Serie geschaltet sind und miteinander verbunden sind, so dass sie die gleiche Gate-Spannung erhalten.

11. Schieberegisterschaltung nach einem der vorhergehenden Ansprüche, wobei die erste bis dritte Eingangsleitung konfiguriert sind, drei verschiedene phasenverschobene Taktsignale zu erhalten.

12. Schieberegisterschaltung nach Anspruch 11, weiterhin aufweisend erste bis vierte Taktsignalleitungen (CLK1, CLK2, CLK3, CLK4), die zur Bereitstellung erster bis vierter Taktsignale ausgebildet sind, wobei das erste Taktsignal eine um einen ausgewählten Betrag phasenverschobene Version des vierten Taktsignals ist und das zweite bis vierte Taktsignal jeweils um den ausgewählten Betrag phasenverschobene Versionen des nachfolgenden vorhergehenden Taktsignals sind, wobei die erste, zweite und dritte Signaleingangsleitung zumindest einer der Registerstufen konfiguriert sind, das vierte, dritte beziehungsweise erste Taktsignal zu erhalten.

13. Schieberegisterschaltung nach einem der vorhergehenden Ansprüche, wobei jeder der n Registerstufen weiterhin aufweist:
einen ersten Kondensator, der zwischen die erste Spannungsversorgung (Vpos) und den ersten Knoten (Qnode) gekoppelt ist;
einen zweiten Kondensator, der zwischen die erste Spannungsversorgung (Vpos) und den zweiten Knoten (QBnode) gekoppelt ist; und
einen Speicherkondensator, der zwischen den ersten Knoten (Qnode) und die Ausgangsleitung gekoppelt ist.

14. Schieberegisterschaltung nach Anspruch 1, wobei wenigstens einer des sechsten Transistorabschnitts, des siebten Transistorabschnitts, oder des achten Transistorabschnitts einen einzelnen Transistor aufweist.

15. Anzeigetafel, aufweisend die Schieberegisterschaltung nach einem der vorhergehenden Ansprüche.

## Revendications

1. Circuit de registre à décalage comprenant n étages de registre (étage 1, étage 2, étage 3, étage 4, étage n), dans lequel n est un entier, et chaque étage de registre (étage 1, étage 2, étage 3, étage 4, étage n) comprend quatre lignes d'entrée, les première à troisième lignes d'entrée sont connectées à trois de quatre lignes de fourniture de signal d'horloge (CLK1, CLK2, CLK3, CLK4), et la quatrième ligne d'entrée est connectée à une ligne d'entrée d'impulsion de départ (SP) ou à une ligne de tension de sortie (g1, g2, g3, gn-1) d'un étage de registre précédent (étage 1, étage 2, étage 3, étage 4), dans lequel chacun des n étages de registre (étage 1, étage 2, étage 3, étage 4, étage n) comprend :
un étage d'entrée comprenant un premier transistor (M1), un deuxième transistor (M2) et un troisième transistor (M3) et des sixième et septième sections à transistors ; et
un étage de sortie comprenant un quatrième transistor (M4) et un cinquième transistor (M5) configurés pour recevoir des première et deuxième entrées complémentaires en provenance de l'étage d'entrée ;
dans lequel l'étage d'entrée est configuré de façon que chaque fois que la première entrée a un premier niveau logique, la deuxième entrée est attaquée de façon à avoir un niveau logique opposé au premier niveau logique ;
dans lequel
le premier transistor (M1) comprend une première électrode de grille et une première électrode de drain, la première grille et le premier drain étant reliés à une ligne de tension de sortie (gi-1) d'un étage de registre précédent ou à une première ligne d'entrée d'impulsion de départ (SP) ;
le deuxième transistor (M2) est relié entre un premier noeud (Qnode) et le premier transistor (M1) et comprend une deuxième électrode de grille, la deuxième électrode de grille étant reliée à une première ligne de signal d'horloge ;
le troisième transistor (M3) est constitué d'une troisième électrode de grille, la troisième électrode de grille étant reliée à une deuxième ligne de signal d'horloge ;
le quatrième transistor (M4) est relié à un deuxième noeud (QBnode), à une première alimentation électrique (Vpos) et à une ligne de tension de sortie (Vout) de l'étage de registre courant ;
le cinquième transistor (M5) est relié au premier noeud (Qnode), à une troisième ligne de signal d'horloge et à la ligne de tension de sortie (Vout) de l'étage de registre courant ;
la sixième section à transistors (M6-1, M6-2) est reliée à la première alimentation électrique (Vpos), au deuxième noeud (QBnode) et au premier noeud (Qnode) ; et
la septième section à transistors (M7-1, M7-2) est reliée à la première alimentation électrique (Vpos), à la ligne d'entrée d'impulsion de départ ou à la ligne de tension de sortie d'un étage de registre précédent ;
chacun des n étages de registre étant **caractérisé par :**
**le fait que** le troisième transistor de l'étage d'entrée est relié entre le deuxième noeud (QBnode) et une deuxième alimentation électrique (Vneg) ; l'étage d'entrée de chaque étage de registre comprenant en outre :
une huitième section à transistors (M8-1, M8-2) reliée à la première alimentation électrique (Vpos), au premier noeud (Qnode) et au deuxième noeud (QBnode).

2. Circuit de registre à décalage selon la revendication précédente, dans lequel chacun des n étages de registre (étage 1, étage 2, étage 3, étage 4, étage n) est configuré pour recevoir trois signaux d'horloge déphasés différents (CLK1, CLK2, CLK3, CLK4) et une impulsion de départ (SP, g1, g2, g3, gn-1).

3. Circuit de registre à décalage selon l'une des revendications précédentes, dans lequel chaque étage du registre (étage 1, étage 2, étage 3, étage 4, étage n) est configuré pour fournir en sortie une impulsion unique (Vout 1, Vout 2, Vout 3, Vout 4, Vout n) en réponse aux trois signaux d'horloge déphasés différents et à l'impulsion de départ (SP, g1, g2, g3, gn-1).

4. Circuit de registre à décalage selon la revendication 1, dans lequel les premier à cinquième transistors sont des transistors PMOS.

5. Circuit de registre à décalage selon la revendication 1, dans lequel les sections à transistors sont des transistors PMOS.

6. Circuit de registre à décalage selon la revendication 1, dans lequel les premier à cinquième transistors sont des transistors NMOS.

7. Circuit de registre à décalage selon la revendication 1, dans lequel les sections à transistors sont des transistors NMOS.

8. Circuit de registre à décalage selon la revendication 1, dans lequel la sixième section à transistors comprend un sixième-1 et un sixième-2 transistor, dans lequel les sixième-1 et sixième-2 transistors sont connectés l'un à l'autre en série et sont connectés l'un à l'autre de façon à recevoir la même tension de grille.

9. Circuit de registre à décalage selon la revendication 1, dans lequel la septième section à transistors comprend un septième-1 transistor et un septième-2 transistor, dans lequel le septième-1 transistor et le septième-2 transistor sont connectés l'un à l'autre en série et sont connectés l'un à l'autre de façon à recevoir la même tension de grille.

10. Circuit de registre à décalage selon la revendication 1, dans lequel la huitième section à transistors comprend un huitème-1 transistor et un huitième-2 transistor, dans lequel les huitième-1 et huitième-2 transistors sont connectés l'un à l'autre en série et sont connectés l'un à l'autre de façon à recevoir la même tension de grille.

11. Circuit de registre à décalage selon l'une des revendications précédentes, dans lequel les première à troisième lignes d'entrée sont configurées pour recevoir trois signaux d'horloge déphasés différents.

12. Circuit de registre à décalage selon la revendication 11, comprenant en outre des première à quatrième lignes de signaux d'horloge (CLK1, CLK2, CLK3, CLK4) aptes à fournir des premier à quatrième signaux d'horloge, dans lequel le premier signal d'horloge est une version du quatrième signal d'horloge déphasée d'une quantité sélectionnée et les deuxième à quatrième signaux d'horloge sont chacun des versions du signal d'horloge immédiatement précédent déphasées de la quantité sélectionnée, dans lequel les première, deuxième et troisième lignes d'entrée de signal d'au moins l'un des étages du registre sont configurées pour recevoir respectivement les quatrième, troisième et premier signaux d'horloge.

13. Circuit de registre à décalage selon l'une des revendications précédentes, chacun des n étages du registre comprenant en outre :
un premier condensateur relié entre la première alimentation électrique (Vpos) et le premier noeud (Qnode) ;
un deuxième condensateur relié entre la première alimentation électrique (Vpos) et le deuxième noeud (QBnode) ; et
un condensateur de stockage relié entre le premier noeud (Qnode) et la ligne de sortie.

14. Circuit de registre à décalage selon la revendication 1, dans lequel au moins l'une de la sixième section à transistors, de la septième section à transistors et de la huitième section à transistors comprend un transistor unique.

15. Panneau d'affichage comprenant le circuit de registre à décalage selon l'une des revendications précédentes.
